# EUROPEAN PATENT SPECIFICATION

(11) **EP 0 897 579 B1**
(45) Date of publication and mention of the grant of the patent: **26.07.2000**
(21) Application number: 97920848.5
(22) Date of filing: 08.05.1997
(51) Int. Cl.: G11C 7/00, G06F 5/06

(54) **MEMORY DEVICE**
SPEICHERANORDNUNG
DISPOSITIF DE MEMOIRE

(30) Priority: 10.05.1996 GB 9609833
(43) Date of publication of application: 24.02.1999
(73) Proprietor: Memory Corporation plc, Dalkeith, Edinburgh EH22 2NA (GB)
(72) Inventor: SINCLAIR, Alan, Welsh, Cambridge CB4 4TA (GB)
(74) Representative: MacDougall, Donald Carmichael
(86) International application number: GB9701241
(87) International publication number: WO9743764

(56) References cited:
- EP-A- 0 436 104
- EP-A- 0 509 722
- US-A- 4 271 480
- US-A- 4 297 567
- US-A- 4 507 760
- US-A- 4 942 553
- US-A- 5 410 308
- US-A- 5 495 552
- PATENT ABSTRACTS OF JAPAN vol. 6, no. 100 (P-121), 9 June 1982 & JP 57 033469 A (HITACHI)

## Description

This invention relates to electronic memory devices and, in particular, it relates to memory devices which are capable of storing data in variable length blocks of data.

Memory systems are used to store data. As data storage requirements increase memory device capacity must also increase. To avoid having to use memories that are physically large or contain a large number of cells, many memory systems incorporate data compression. Data compression is appealing because it has the advantage of increasing the amount of data that can be stored in a memory device without increasing the physical size of the memory device. A number of different data compression techniques exist. Some of these techniques are implemented by hardware others are implemented by software.

In European patent application No. EP 0436104A2 (National Semiconductor) a data communications system with multiple ports using shared data has a transceiver with a FIFO data store. During data reception, a comparator compares a subset of the incoming data with a predetermined reference to decide whether the data should be stored or aborted. This operation sets a memory address value for a commit pointer. The first subset of data behind the commit pointer is selectively stored and the subset after the point is selectively aborted. The reason for this operation is to select data appropriate for the particular port.

In European patent application No. EP 0509722 A2 (NEC) a multiple processor system has an I/O buffer with a predetermined number of buffer areas. An external pointer stores an address corresponding to the initial position of one of the buffer areas. The address is calculated with reference to the ratio of the length of a data block to be transferred and the total length of the buffer areas.

In US patent No. 4297567 (Philips) a content addressable FIFO memory in which the stored signal is addressed in a mode determined by the content of the stored signal. Instructions for processing the signal are stored in a the same memory as a contiguous signal.

In US patent No. 4507760 (AT&T) a FIFO memory system has an addressable cyclic store, a write pointer, a read pointer and a last-word pointer for identifying the end of a multiword message. Before a write operation a comparator checks that the write and read pointers are not at the same setting.. Before reading a comparator checks that the read pointer and the last-word pointer are not at the same setting. The contents of the write pointer are copied to the last-word pointer register on receipt of an end-of-message signal. On identification of an error in a new memory word, the last word pointer is copied to the write pointer register.

In US patent No. US 5410308 (Deutsche Thomson-Brandt) a video signal storage system encodes pixels into variable length data words dependent on discrete cosine transformation of DC and AC components of a pixel. The encoder has an address flag to indicate whether or not a transport block contains data from segmented data blocks having a length greater than a predetermined average length and makes provision for storing such data elsewhere.

In US patent No. 5495552 (Mitsubishi) an audio signal is encoded into several hierarchical levels of data corresponding to increasing levels of fidelity. After the available memory is full, recording continues by over-writing successively lower hierarchical level levels. At the conclusion a code is recorded indicating the number of hierarchical levels to be reproduced.

US patent No. 4942553 (Zilog) discloses that, in a FIFO memory device controlling data transfer between a microprocessor and peripheral devices, memory over-runs, with consequent loss of data, and under-runs, with consequent transmission of garbage, are obviated by having two user programmable levels for generating a notification to the DMA or co-processor when action is required.

In US patent No. 4271480 (Honeywell-Bull) a FIFO store has an input and output interface with stores for input and output data words. Flags indicated when the input and FIFO stores are empty and ready to receive data. A controller sets the width of the output data words in response to an external signal.

In Japanese patent application No. 57033469 (Hitachi) increase of throughput and restriction of use of buffer memory is obtained by storing a pointer to the end of stored data. The system employs read, write and data end pointers. Writing is inhibited after the write pointer reaches the value stored in the end pointer. Erasure takes place asynchronously with reading and is controlled by the end pointer.

Implementing efficient data compression in memory systems is not simple because the files are split into a number of fixed data block sizes called sectors. If files are compressed before they are split into sectors then there is no problem because each sector except the final sector is full of compressed data. If, however, files are split into sectors before data compression is applied then the compressed sectors will not be of a standard length, they will be of variable length. That is, one sector may compress to half its original size, whereas another sector may compress to a quarter of its original size. Sectors do not all compress to a common size.

Consider the following case. A sector is compressed and stored at a memory location, a second sector is then compressed and stored in the memory location immediately adjacent to it. If the first sector is then altered it might not be compressed to the same size as before. If it is larger than it was before then it will not fit into the memory space it previously occupied; if it is smaller than it was before then there will be wasted memory space causing disk fragmentation. Disk fragmentation reduces the storage efficiency of the memory device which may offset the benefits gained by data compression.

The invention is concerned with a memory device which stores variable length groups of data such as the groups produced by data compression of fixed length sectors of data.

Accordingly, the present invention provides an addressable memory device for storing data arranged in groups, said groups of data not being of a fixed length, comprising a memory, a write pointer adapted to indicate an address of the next set of locations to which data are to be written and an erase pointer adapted to indicate the address of the next location from which data are to be erased wherein a sector header is appended to each group of stored data, the location stored by the write pointer being selected to ensure that there is always at least one set of erased memory location adjacent to the set of locations indicated by said write pointer.

An embodiment of the present invention will now be particularly described, by way of example, with reference to the accompanying drawing in which:
Figure 1 shows a diagram of a block-erasable memory; and
Figure 2 shows a diagram of a sector header.

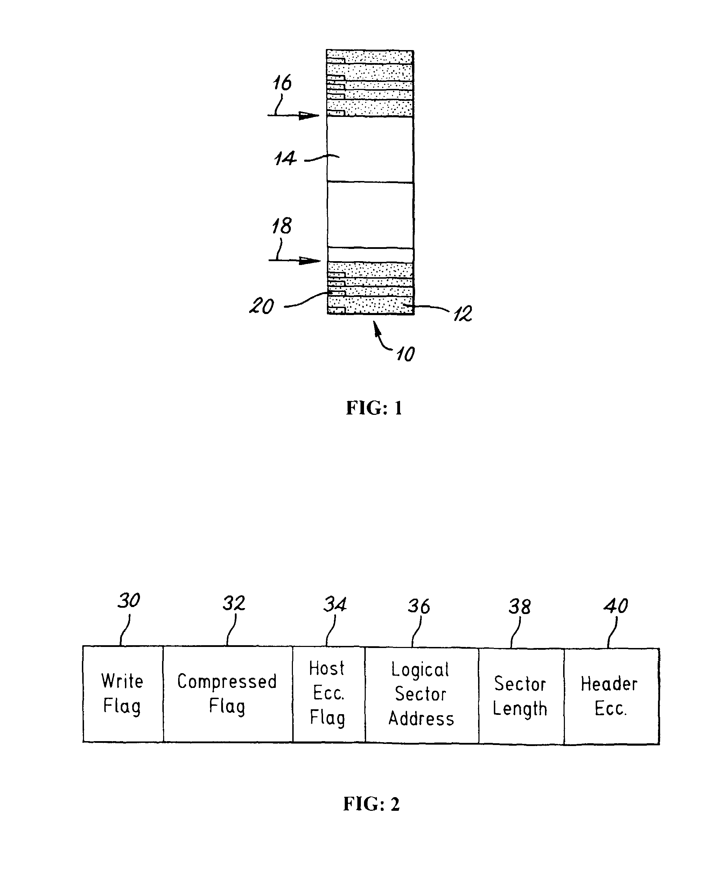

Figure 1 shows an addressable block-erasable memory 10 for storing sectors of data 12, where a sector is not of fixed length. The minimum area of memory that can be erased in an erase operation is called an erase block. The memory 10 has an erase pointer 16 which indicates the next erase block of memory from which data are to be erased and a write pointer 18 which indicates the next location to which data are to be written. These two pointers (16,18) are separated by at least one erase block 14 in the erased state. The erase pointer 16 points to the first sector in an erase block. The write pointer 18 points to the area of memory space to be written to, that is, the memory location immediately adjacent to the sector 12 that was most recently written. After a sector 12 is written, the write pointer 18 is incremented past the end of that sector 12. Any sectors 12 written to the memory 10 directly from a host are compressed according to the compression technique being implemented and stored at the location defined by the write pointer 18.

The pointers (16,18) cycle through the memory space ensuring that the two pointers are separated by at least one erase block 14 in the erased state. Obsolete sectors in the erase block 14 that is currently pointed to by the erase pointer 16 are not relocated; whereas any sectors in that erase block 14 containing valid data are relocated to the location currently indicated by the write pointer 18. Once all of the valid sectors in an erase block 14 have been relocated the erase block 14 is erased and the erase pointer 16 is incremented to point to the first sector 12 in the next erase block 14.

Each sector of data 12 has a sector header 20 associated with it. The sector header is used to indicate how long the sector is and to store control information relating to the sector. The sector header 20 contains a number of fields, as shown in Figure 2.

A write flag 30 consists of one bit which is used to show whether or not data have been written to the sector 12. The write flag 30 is set when a sector of data is written and is cleared whenever an erase block 14 is erased. A compressed flag 32 is a single data bit which is used to indicate whether or not the data in the sector 12 are compressed. The compressed flag 32 is set when the sector data arc compressed. A host error correction code (ECC) flag 34 is used when an ECC for a sector is transmitted with the sector data from the host.

A logical sector address field 36 is composed of a plurality of data bits. The logical sector address field 36 is used to store the logical sector address as defined by the host. The logical sector address is the address generated by the host. The number of bits required for the logical sector address 36 will depend on the physical size of the memory.

A sector length field 38 is used to indicate the length of the sector data stored in the block-erasable memory 10. There may also be a header ECC field 40 for providing a means of checking the integrity of the data stored in the sector header 20.

By reading the sector header field 20 the write pointer 18 can calculate where the end of the sector will be. Every time a sector is altered it is relocated so that the sector starts at the memory location adjacent to the sector that was written most recently. Since there is always at least one erase block 14 in the erased condition adjacent to the write pointer 18, a data sector 12 can always be written at the location defined by the write pointer 18. Thus the present invention ensures that data compression techniques can be used efficiently with block erasable memories.

In the above embodiment, the sector length field, which is included in the header defines the logical length of the sector and that logical length may change if data compression is used. In an alternative embodiment the sector length field stores the physical length of the sector. The physical length may vary for two reasons, firstly, if the logical length is variable, perhaps because of data compression and secondly, to accommodate defective memory locations. If a sector spans both good and defective memory regions, the physical length must be altered to take account of the extra addresses which must be allocated because faulty memory cannot be accessed.

It will be appreciated that various modifications may be made to the above described embodiment within the scope of the present invention. For example the present invention may be used with a memory that is byte erasable rather than block-erasable. Some embodiments of the present invention may not use any form of error checking or correction codes.

## Claims

1. An addressable memory device for storing data arranged in groups (12), said groups of data not being of a fixed length, comprising a memory (10), a write pointer (18) adapted to indicate an address of the next set of memory locations to which data are to be written and an erase pointer (16) adapted to indicate the address of the next memory location from which data are to be erased,
characterised in that a group header (20) is appended to each group of stored data, and there is always at least one set of erased memory locations adjacent to the set of memory locations indicated by said write pointer.

2. An addressable memory device for storing groups of data according to claim 1, characterised in that each group header contains information (38) to indicate the length of the corresponding group of data.

3. An addressable memory device for storing groups of data according to any preceding claim, characterised in that the group header contains means (36) for indicating the address generated by the host.

4. An addressable memory device for storing groups of data according to any preceding claim, characterised in that the group header contains means (40) for correcting or checking the data bits in the said group header.

5. An addressable memory device for storing groups of data according to any preceding claim, characterised in that the group header contains means (20) for indicating whether the group data has been compressed or not.

6. An addressable memory device for storing groups of data according to any preceding claim, characterised in that the physical memory locations (14) between the write pointer and the erase pointer are held in the erased state.

7. An addressable memory device for storing groups of data according to any preceding claim, characterised in that said memory (10) comprises a plurality of erasable blocks of memory locations and there is always at least one erased erasable block between the write and erase pointers.

8. A computer system including an addressable memory device according to any one of the preceding claims.

## Patentansprüche

1. Adressierbare Speichereinrichtung zum Speichern von in Gruppen (12) angeordneten Daten, wobei die Gruppen von Daten nicht von einer festen Länge sind, aufweisend einen Speicher (10), einen Schreibezeiger (18), der ausgelegt ist, um eine Adresse des nächsten Satzes von Speicherstellen anzuzeigen, auf welche Daten geschrieben werden sollen, und einen Löschzeiger 16, der ausgelegt ist, um die Adresse der nächsten Speicherstelle anzuzeigen, von welcher Daten gelöscht werden sollen, dadurch gekennzeichnet, daß ein Gruppenkopf (20) an jede Gruppe von gespeicherten Daten angehängt ist und es immer zumindest einen Satz von gelöschten Speicherstellen neben dem Satz von Speicherstellen gibt, die durch den Schreibezeiger angezeigt sind.

2. Adressierbare Speichereinrichtung zum Speichern von Gruppen von Daten nach Anspruch 1, dadurch gekennzeichnet, daß jeder Gruppenkopf Information (38) enthält, um die Länge der entsprechenden Gruppe von Daten anzuzeigen.

3. Adressierbare Speichereinrichtung zum Speichern von Gruppen von Daten nach einem der vorangegangenen Ansprüche, dadurch gekennzeichnet, daß der Gruppenkopf eine Einrichtung (36) zum Anzeigen der durch den Host erzeugten Adresse enthält.

4. Adressierbare Speichereinrichtung zum Speichern von Gruppen von Daten nach einem der vorangegangenen Ansprüche, dadurch gekennzeichnet, daß der Gruppenkopf eine Einrichtung (40) zum Korrigieren oder Prüfen der Datenbits in dem Gruppenkopf enthält.

5. Adressierbare Speichereinrichtung zum Speichern von Gruppen von Daten nach einem der vorangegangenen Ansprüche, dadurch gekennzeichnet, daß der Gruppenkopf eine Einrichtung (20) zum Anzeigen enthält, ob die Gruppendaten komprimiert worden sind oder nicht.

6. Adressierbare Speichereinrichtung zum Speichern von Gruppen von Daten nach einem der vorangegangenen Ansprüche, dadurch gekennzeichnet, daß die physikalischen Speicherstellen (14) zwischen dem Schreibezeiger und dem Löschzeiger in dem gelöschten Zustand gehalten werden.

7. Adressierbare Speichereinrichtung zum Speichern von Gruppen von Daten nach einem der vorangegangenen Ansprüche, dadurch gekennzeichnet, daß der Speicher (10) eine Vielzahl von löschbaren Blöcken von Speicherstellen aufweist und es immer zumindest einen gelöschten löschbaren Block zwischen den Schreibe- und Löschzeigern gibt.

8. Computersystem, das eine adressierbare Speichereinrichtung nach irgendeinem der vorangegangenen Ansprüche einschließt.

## Revendications

1. Dispositif de mémoire adressable pour stocker des données agencées selon des groupes (12), lesdits groupes de données n'étant pas d'une longueur fixe, comprenant une mémoire (10), un pointeur d'écriture (18) adapté pour indiquer une adresse du jeu suivant d'emplacements de mémoire au niveau desquels des données doivent être écrites et un pointeur d'effacement (16) adapté pour indiquer l'adresse de l'emplacement de mémoire suivant au niveau duquel des données doivent être effacées, caractérisé en ce qu'un en-tête de groupe (20) est annexé à chaque groupe de données stockées et en ce qu'il y a toujours au moins un jeu d'emplacements de mémoire effacés adjacent au jeu d'emplacements de mémoire indiqués par ledit pointeur d'écriture.

2. Dispositif de mémoire adressable pour stocker des groupes de données selon la revendication 1, caractérisé en ce que chaque en-tête de groupe contient une information (38) pour indiquer la longueur du groupe de données correspondant.

3. Dispositif de mémoire adressable pour stocker des groupes de données selon l'une quelconque des revendications précédentes, caractérisé en ce que l'en-tête de groupe contient un moyen (36) pour indiquer l'adresse générée par l'hôte.

4. Dispositif de mémoire adressable pour stocker des groupes de données selon l'une quelconque des revendications précédentes, caractérisé en ce que l'en-tête de groupe contient un moyen (40) pour corriger ou vérifier les bits de données dans ledit en-tête de groupe.

5. Dispositif de mémoire adressable pour stocker des groupes de données selon l'une quelconque des revendications précédentes, caractérisé en ce que l'en-tête de groupe contient un moyen (20) pour indiquer si les données de groupe ont été comprimées ou non.

6. Dispositif de mémoire adressable pour stocker des groupes de données selon l'une quelconque des revendications précédentes, caractérisé en ce que les emplacements de mémoire physiques (14) entre le pointeur d'écriture et le pointeur d'effacement sont maintenus dans l'état effacé.

7. Dispositif de mémoire adressable pour stocker des groupes de données selon l'une quelconque des revendications précédentes, caractérisé en ce que ladite mémoire (10) comprend une pluralité de blocs effaçables d'emplacements de mémoire et en ce qu'il y a toujours au moins un bloc effaçable effacé entre les pointeurs d'écriture et d'effacement.

8. Système d'ordinateur incluant un dispositif de mémoire adressable selon l'une quelconque des revendications précédentes.
